# EUROPEAN PATENT SPECIFICATION

(11) **EP 1 448 654 B1**
(45) Date of publication and mention of the grant of the patent: **13.09.2006**
(21) Application number: 02783838.2
(22) Date of filing: 27.11.2002
(51) Int. Cl.: C08G 59/68, G03F 7/004, G03F 7/038

(54) **RADIATION CURABLE RESIN COMPOSITION FOR MAKING COLORED THREE DIMENSIONAL OBJECTS**
STRAHLENHÄRTBARE ZUSAMMENSETZUNG UM GEFÄRBTE DREIDIMENSIONALE OBJEKTE ANZUFERTIGEN
COMPOSITION DE RESINE DURCISSABLE PAR RAYONNEMENT DESTINEE A LA FABRICATION D'OBJETS TRIDIMENSIONNELS COLORES

(30) Priority: 27.11.2001 US 333138 P
(43) Date of publication of application: 25.08.2004
(73) Proprietor: DSM IP Assets B.V., 6411 TE Heerlen (NL)
(72) Inventor: THOMMES, Glen, Anthony, Wilmington, DE 19803 (US); LAWTON, John, Alan, Landenberg, PA 19350 (US); YOU, Xiaorong, Bear, DE 19701 (US)
(74) Representative: Renkema, Jaap
(86) International application number: PCT/NL2002/000771
(87) International publication number: WO 2003/046042

(56) References cited:
- WO-A-00/07071
- WO-A-96/21704
- US-A- 4 659 649
- US-A- 5 665 792
- US-A- 6 133 335
- US-B1- 6 291 059

## Description

### BACKGROUND OF THE INVENTION

### Field of the invention

The present invention relates to methods for making colored three dimensional objects.

### Description of related art

Methods for producing three dimensional objects are known in the field. An example of such a method is stereolithography. This method comprises in general the steps of irradiating a liquid surface of a liquid photo-curable resin composition kept in a container with ultraviolet laser beams selectively under the control of a computer so as to obtain a desired pattern to cure it to a predetermined thickness, supplying the liquid photo-curable resin composition in an amount enough to form one layer thereof on top of the cured layer, irradiating it with ultraviolet laser beams likewise to cure the resin so as to form a continuous and integral cured layer, and repeating this lamination procedure until a three-dimensional object having a final shape is obtained. In this case, even if the shape of the model is rather complex, a desired three-dimensional object can be produced easily in a relatively short period of time. Therefore, this method has been attracting much attention in recent years. Three dimensional objects may also be obtained when the resin is present in the form of a paste or high viscosity liquid. In that case alternative methods of application of the successive layers may be applied. Also other ways of curing of successive layers may be applied, like for example thermal curing or curing with visible light.

In recent years, three-dimensional objects obtained by the optical stereolithography have been developed from concept models to practical applications such as test models, prototypes or the like. Along with this development, the three-dimensional objects have been required to have high dimensional accuracy, excellent shape stability and excellent mechanical properties. In addition, along with development of application and expansion of demand for three-dimensional objects by optical stereolithography, colored three-dimensional objects, which give a massive impression, which are colorful and also have the above excellent properties or, depending on an application, colored three-dimensional objects having light-shielding properties are now in great demand.

### Object of the invention

The present invention provides a process to make colored three dimensional objects by exposing radiation curable compositions to radiation. Furthermore the present invention provides a process in which relatively low amounts of irradiation may be used for effecting both cure of the resin and coloring of the object.

### Summary of the invention.

The present invention provides a process as defined in the claims

The resin composition used in the process of the present invention may show the natural color of a typical resin that is known in the field, ranging from yellow or amber to completely colorless for transparant resins or white for filled resins. Preferably the resin is substantially colorless, which means that the resin composition shows an absorbance of visible light in the region between 400 and 650 nm of less than 0.3, preferably less than 0.2, more preferably less than 0.1, measured on a sample having a thickness of 1 cm. The absorbance is measured on a UV-VIS spectrophotometer in accordance with ASTM E1164-94.

In the case that the resin contains a filler, measurement of color with light transmittance is impossible, since the filler will reflect the light. In that case measuring reflectance of light will give good results. In case that the resin composition is for example transparent, but the three dimensional object is opaque, than different methods may be used to measure either absorbance (for a clear resin composition or three dimensional object) or reflectance (for an opaque object or resin composition, or for example for a resin or object that contains a filler). These methods and principles are all described in ASTM E 1164-94. The reflectance measurement is carried out with a chroma meter, or color spectrophotometer.

The resin composition used in the present invention contains a latent coloring component C) that is a substantially colorless dye precursor capable of forming a chromophore in the presence of reactive components in the resin that are formed during irradiation of the resin. It is believed that especially the photoacid that is formed during irradiation of the cationic photoinitiator is one of the active components that reacts with the latent coloring component C) to generate a chromophore that gives color to the resin composition or to the three dimensional part.

The presence of the latent coloring component C) has at least two advantages. One advantage is that the resin composition has a first color (or no color), while the part shows a distinctly different second color. This difference in color facilitates the observation of the part building process, is appealing to the eye and gives a part that is colored throughout the whole part. This will reduce the time that is used in finishing the part, for example by removing support structures used to build the part and for example by surface coloring or painting of the product for a customer. Another advantage is also that it is easier to clean off excess resin because the part and resin are easily differentiated. Thus the cleaning of the part can be more complete and effective. This is especially advantageous when filled resin compositions are used that have high viscosities or are paste-like.

Another advantage is that the quality of the resin composition can be monitored by measuring the color of the resin in the vat of the SL-machine. In the ideal situation, the appearance of the resin will be colorless or the resin will have its natural yellowish or amber appearance for transparant resins, or white for filled resins. Due to stray and transmitted radiation from normal part building some strong acid (cationic initiating species) may be formed in the vat. This strong acid can start, albeit at slow rate, chain addition polymerization of epoxide moieties in the resin, and because this polymerization does not have a naturally occurring chain termination process (as opposed to free radical chain addition polymerization, where bimolecular radical reactions such as coupling or disproportionation can terminate the chain process) the slow chain addition polymerization can continue and ultimately increases resin viscosity to a point where part preparation and clean-up is virtually impossible and the resin must be replaced. It is believed that this photoacid will react with the component C) in the resin upon formation of a colored complex. So the resin will start showing a slight color when the amount of photoacid increases. The color change is an indicator of a viscosity increase of the resin composition. The color change can be easily reversed by adding a neutralizing amount of a hydroxylic base, e.g., tetramethyl ammonium hydroxide in an organic solvent. This base will irreversibly react with the photoacid and thereby stop the polymerization reaction and viscosity build of the resin. Also the color of the resin, which is believed to be due to the (reversible) reaction between photoacid and compound C) will substantially disappear.

Another advantage of the invention is, that irregularities that may occur in the process can be easily monitored and corrected. Sometimes formation of unwanted three dimensional structures occurs, due to side reactions, mistakes in the process, breakage of parts during build etc. The unwanted structures may float in the resin and may cause problems with building of new parts by interfering with the stereolithography process. This problem is even more pronounced with filled resins since the density difference between resin and three dimensional object are rather low. The presence of color in the structures helps in identifying such pieces and in removing them from the vat/resin.

The three dimensional part made by the process of the present invention will show a color. Preferably this color is uniform throughout the entire part. Different ways for measuring color exist. One may use absorbance measurements for transparent resins and/or parts, or color measurements for opaque and transparent resins and/or parts. For instance a transparent part preferably shows a maximum absorbance (in case the part is substantially transparent) of visible light of at least 1.0 measured in the range from 400 to 650 nm on a sample having a thickness of 250 mil (or 0.635 cm). Preferably the maximum absorbance is more than 1.5. More preferably the maximum absorbance is more than 2.0.

Measurement of color can be performed with a Chroma meter. In case the resin composition and/or part are opaque due to for example the presence of a filler, the color of the resin and the part is measured with a Chroma meter on the part or resin as such. When the part or resin is transparent, measurement of the color is performed against a white background. A Chroma meter will give three values in the L*a*b color space (CIELAB 1976). The lightness (L) will be 100 for white materials and 0 for totally black materials. The 'a' and 'b' values represent the actual color: The '-a' value represents green, '+a' represents red, '-b' represents blue and '+b' is yellow. The 'a' value is between -60 and +60, 'b' is between -60 and + 60. Parts having an 'a' and 'b' value between -20 and 20 will have a rather grey appearance. Parts having 'a' and 'b' values between -20 and -60 or 20 and 60 will be more colorful. The conventional resin compositions with and without fillers but no component C) will show large L values between 90 and 100. Parts made by UV-curing a resin of the present invention will show a different color than the resin. This different color may be expressed as a change in L value, 'a' value or 'b' value relative to the resin. In case the L value does not change much (for example the color changes from red to blue), the 'a' or 'b' value will change at least with 20 units, preferably with 30 units. In most cases however, the L value of the part will change relative to the resin, so that cured parts will have L-values between 0 and 85, preferably between 20 and 75. The 'a' and/or 'b' value of the cured part may stay the same as the values of the resin, as long as the L-value changes. Preferably the 'a' and /or 'b' value of a part will change by at least 10 units after cure of the resin. For instance the 'a' and/or 'b' value will change by at least 20 units.

An alternative way of indicating the color change that occurs after curing the resin composition of the present invention is by using the ratio Lc/Lu, wherein Lc is L of the cured part, and Lu is L of the uncured resin. Lc/Lu is preferably <0.95, more preferably < 0.9 or < 0.85. Lc and Lu are measured on a sample having a thickness of 20 mil (0.5 mm) or more, with a white Lengta-card background.

The resin compositions used in the present invention may have cationically curable components A), and/or radically curable components D) as well as cationic photoinitiators B) and/or radical photoinitiators E). In case the compositions of the invention contain a filler F), the resin may be based on cationically curable components, radically curable components or mixtures of these components (so called hybrid systems). When the compositions do not contain fillers, the resin may be preferably based on cationically curable components like epoxy components or hybrid systems.

Component A is at least one epoxy compound or a mixture of different epoxy compounds. Epoxy compounds are compounds that possess on average at least one 1,2-epoxide group in the molecule. By "epoxide" is meant the three-membered ring having a structure represented by

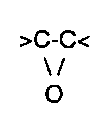

The epoxide-containing materials, also referred to as epoxy materials, are cationically curable, by which is meant that polymerization and/or crosslinking of the epoxy group may be initiated by cations. The materials can be monomers, oligomers or polymers and are sometimes referred to as "resins." Such materials may have an aliphatic, aromatic, cycloaliphatic, arylaliphatic or heterocyclic structure; they may comprise epoxide groups as side groups, or the epoxy groups may form part of an alicyclic or heterocyclic ring system. Epoxy groups may also be bound to for example siloxane containing backbones. Epoxy resins of those types are generally known and are commercially available.

The epoxide-containing material (A) may for instance comprise at least one liquid component such that the combination of materials is a liquid. Thus, the epoxide-containing material can be a single liquid epoxy material, a combination of liquid epoxy materials, or a combination of liquid epoxy material(s) and solid epoxy material(s) which is soluble in the liquid.

Examples of suitable epoxy materials include polyglycidyl and poly(methylglycidyl) esters of polycarboxylic acids, poly(oxiranyl) ethers of polyethers or epoxidised unsaturated fatty acids. The polycarboxylic acid can be aliphatic, such as, for example, glutaric acid, adipic acid and the like; cycloaliphatic, such as, for example, tetrahydrophthalic acid; or aromatic, such as, for example, phthalic acid, isophthalic acid, trimellitic acid, or pyromellitic acid. The polyether can be poly(tetramethylene oxide). It is likewise possible to use carboxyterminated adducts, for example, of trimellitic acid and polyols, such as, for example, glycerol or 2,2-bis(4-hydroxycyclohexyl)propane. Suitable epoxidised unsaturated fatty acids may be obtained from for example linseed oil or perilla oil.

Suitable epoxy materials also include polyglycidyl or poly(-methylglycidyl) ethers obtainable by the reaction of a compound having at least one free alcoholic hydroxy groups and/or phenolic hydroxy groups and a suitably substituted epichlorohydrin. The alcohols can be acyclic alcohols, such as, for example, ethylene glycol, diethylene glycol, and higher poly(oxyethylene) glycols; cycloaliphatic, such as, for example, 1,3- or 1,4-dihydroxycyclohexane, bis(4-hydroxycyclohexyl)methane, 2,2-bis(4-hydroxycyclohexyl)propane, or 1,1-bis(hydroxymethyl)cyclohex-3-ene; or contain aromatic nuclei, such as N,N-bis(2-hydroxyethyl)aniline or p,p'-bis(2-hydroxyethylamino)diphenylmethane.

The epoxy compounds may also be derived from mono nuclear phenols, such as, for example, from resorcinol or hydroquinone, or they may be based on polynuclear phenols, such as, for example, bis(4-hydroxyphenyl)methane (bisphenol F), 2,2-bis(4-hydroxyphenyl)propane (bisphenol A), or on condensation products, obtained under acidic conditions, of phenols or cresols with formaldehyde, such as phenol novolacs and cresol novolacs.

Suitable epoxy materials also include poly(N-glycidyl) compounds which are, for example, obtainable by dehydrochlorination of the reaction products of epichlorohydrin with amines that comprise at least two amine hydrogen atoms, such as, for example, n-butylamine, aniline, toluidine, m-xylylene diamine, bis(4-aminophenyl)methane or bis(4-methylaminophenyl)methane. The poly(N-glycidyl) compounds also include, however, N,N'-diglycidyl derivatives of cycloalkyleneureas, such as ethyleneurea or 1,3-propyleneurea, and N,N'-diglycidyl derivatives of hydantoins, such as of 5,5-dimethylhydantoin.

Examples of suitable epoxy materials include poly(S-glycidyl) compounds which are di-S-glycidyl derivatives which are derived from dithiols, such as, for example, ethane-1,2-dithiol or bis(4-mercaptomethylphenyl) ether.

Further examples of epoxide-containing materials are bis(2,3-epoxycyclopentyl)ether, 2,3-epoxy cyclopentyl glycidyl ether, 1,2-bis(2,3-epoxycyclopentyloxy)ethane, bis(4-hydroxycyclohexyl)methane diglycidyl ether, 2,2-bis(4-hydroxycyclohexyl)propane diglycidyl ether, 3,4-epoxycyclohexylmethyl-3,4-epoxycyclohexane, 3,4-epoxy-6-methylcyclohexylmethyl-3,4-epoxy-6-methylcyclohexanecarboxylate, di(3,4-epoxycyclohexylmethyl)hexanedioate, di(3,4-epoxy-6-methylcyclohexylmethyl)hexanedioate, ethylenebis(3,4-epoxycyclohexanecarboxylate), ethanedioldi(3,4-epoxycyclohexylmethyl)ether, vinylcyclohexene dioxide, dicyclopentadiene diepoxide, α-(oxiranylmethyl)-ω-(oxiranylmethoxy) poly(oxy-1,4-butanediyl), diglycidyl ether of neopentyl glycol, or 2-(3,4-epoxycyclohexyl-5,5-spiro-3,4-epoxy)cyclohexane-1,3-dioxane, and combinations thereof.

It is, however, also possible to use epoxy resins in which the 1,2-epoxy groups are bonded to different heteroatoms or functional groups. Those compounds include, for example, the N,N,O-triglycidyl derivative of 4-aminophenol, the glycidyl ether glycidyl ester of salicylic acid, N-glycidyl-N'-(2-glycidyloxypropyl)-5,5-dimethylhydantoin, or 2-glycidyloxy-1,3-bis(5,5-dimethyl-1-glycidylhydantoin-3-yl)propane.

In addition, prereacted adducts of such epoxy resins with hardeners are suitable for epoxy resins.

It is of course also possible to use mixtures of epoxy materials in the compositions according to the invention.

Preferred epoxy materials A) contain cycloaliphatic diepoxides. Especially preferred cycloaliphatic diepoxides are bis(4-hydroxycyclohexyl)methane diglycidyl ether, 2,2-bis(4-hydroxycyclohexyl)propane diglycidyl ether, 3,4-epoxycyclohexylmethyl-3,4-epoxycyclohexanecarboxylate, 3,4-epoxy-6-methylcyclohexylmethyl-3,4-epoxy-6-methylcyclohexanecarboxylate, di(3,4-epoxycyclohexylmethyl)hexanedioate, di(3,4-epoxy-6-methylcyclohexylmethyl)hexanedioate, ethylenebis(3,4-epoxycyclohexanecarboxylate), ethanedioldi(3,4-epoxycyclohexylmethyl) ether, 2-(3,4-epoxycyclohexyl-5,5-spiro-3,4-epoxy)cyclohexane-1,3-dioxane, and combinations thereof.

The epoxy materials can have molecular weights which vary over a wide range. In general, the epoxy equivalent weight, i.e., the number average molecular weight divided by the number of reactive epoxy groups, is preferably in the range of 60 to 1000.

Preferably the composition used in the invention comprises from 30 to 80% by weight of the epoxide containing material A). Weight percentages of components of the resin composition of the present invention are related to the total weight of the radiation curable components of the composition, unless specified otherwise.

Component B) of the present resin composition comprises a cationic photoinitiator. In the compositions according to the invention, any type of photoinitiator that, upon exposure to actinic radiation, forms cations that initiate the reactions of the epoxy material(s) can be used. There are a large number of known and technically proven cationic photoinitiators for epoxy resins that are suitable. They include, for example, onium salts with anions of weak nucleophilicity. Examples are halonium salts, iodosyl salts or sulfonium salts, such as are described in published European patent application EP 153904 and WO 98/28663, sulfoxonium salts, such as described, for example, in published European patent applications EP 35969, 44274, 54509, and 164314, or diazonium salts, such as described, for example, in U.S. Patents 3,708,296 and 5,002,856. Other cationic photoinitiators are metallocene salts, such as described, for example, in published European applications EP 94914 and 94915.

A survey of other current onium salt initiators and/or metallocene salts can be found in "UV Curing, Science and Technology", (Editor S. P. Pappas, Technology Marketing Corp., 642 Westover Road, Stamford, Conn., U.S.A.) Or "Chemistry & Technology of UV & EB Formulation for Coatings, Inks & Paints", Vol. 3 (edited by P. K. T. Oldring).

Preferred cationic photoinitiators are compounds of formula I, II or III below,
(I)

   [R₁-I-R₂]⁺[Qm]⁻
(II) 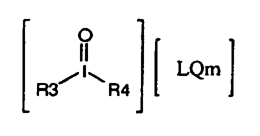
(III) 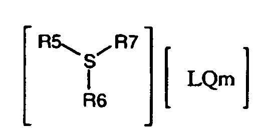
wherein:
R₁, R₂, R₃, R₄, R₅, R₆, and R₇ are each independently of the others C6-C18 aryl-group that may be unsubstituted or substituted by suitable radicals,
L is boron, phosphorus, arsenic, or antimony,
Q is a halogen atom or some of the radicals Q in an anion LQm⁻ may also be hydroxy groups, and
m is an integer that corresponds to the valence of L plus 1.

Examples of C6-C18 aryl are phenyl, naphthyl, anthryl, and phenanthryl. Any substituents present for suitable radicals are alkyl, preferably C1-C6 alkyl, such as methyl, ethyl, n-propyl, isopropyl, n-butyl, sec-butyl, iso-butyl, tert-butyl, or the various pentyl or hexyl isomers, alkoxy, preferably C1-C6 alkoxy such as methoxy, ethoxy, propoxy, butoxy, pentyloxy, or hexyloxy, alkylthio, preferably C1-C6 alkylthio, such as methylthio, ethylthio, propylthio, butylthio, pentylthio, or hexylthio, halogen, such as fluorine, chlorine, bromine, or iodine, amino groups, cyano groups, nitro groups, or arylthio, such as phenylthio.

Examples of preferred halogen atoms Q are chlorine and especially fluorine. Preferred anions LQₘ⁻ are BF₄⁻, PF₆⁻, AsF₆⁻, SbF₆⁻, and SbF₅(OH)⁻.

Especially preferred are compositions comprising as the cationic photoinitiator a compound of formula III wherein R₅, R₆ and R₇ are aryl, aryl being especially phenyl or biphenyl, or mixtures of those two compounds.

Also preferred are compositions comprising as component B) a compound of formula (IV)

[R₈(Fe^{II}R₉)_{c}]_{d}^{+c}[x]_{c}^{-d},

wherein,
c is 1 or 2,
d is 1,2,3,4 or 5,
X is a non-nucleophilic anion, especially PF₆⁻, AsF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻, or n-C₈F₁₇SO₃⁻, R8 is a pi-arene, and R9 is an anion of a pi-arene, especially a cyclopentadienyl anion.

Examples of pi-arenes as R8 and anions of pi-arenes as R9 are to be found in published European patent application EP 94915.

Examples of preferred pi-arenes as R8 are toluene, xylene, ethylbenzene, cumene, methoxybenzene, methylnaphthalene, pyrene, perylene, stilbene, diphenylene oxide and diphenylene sulfide. Especially preferred are cumene, methylnaphthalene, or stilbene.

Examples of nonnucleophilic anions X⁻ are FSO₃⁻, anions of organic sulfonic acids, of carboxylic acids, or anions LQₘ⁻, as already defined above.

Preferred anions are derived from partially fluoro or perfluoroaliphatic or partially fluoro or perfluoro aromatic carboxylic acids, or especially from partially fluoro or perfluoroaliphatic or partially fluoro or perfluoroaromatic organic sulfonic acids, or they are preferably anions LQₘ⁻.

Examples of anions X⁻ are BF₄⁻, PF₆⁻, AsF₆⁻, SbF₆⁻, SbF₅(OH)⁻, CF₃SO₃⁻, C₂F₅SO₃⁻, n-C₃F₇SO₃⁻, n-C₄F₉SO₃⁻, n-C₆F₁₃SO₃⁻, n-C₈F₁₇SO₃⁻, C₆F₅SO₃⁻, phosphorus tungstate, or silicon tungstate. Preferred are PF₆⁻, AsF₆⁻, SbF₆⁻, CF₃S₃O⁻, C₂F₅SO₃⁻, n-C₃F₇SO₃⁻, n-C₄F₉SO₃⁻, n-C₆F₁₃SO₃⁻, and n-C₈F₁₇SO₃⁻.

The metallocene salts can also be used in combination with oxidizing agents. Such combinations are described in published European patent application EP 126712.

The compositions used in the invention preferably comprise from about 0.2 to about 10% by weight of cationic photoinitiator, based on the total weight of the composition.

In order to increase the light efficiency, or to sensitize the cationic photoinitiator to specific wavelengths, such as for example specific laser wavelengths or a specific series of laser wavelengths, it is also possible, depending on the type of initiator, to use sensitizers. Examples of sensitizers are polycyclic aromatic hydrocarbons or aromatic keto compounds. Specific examples of preferred sensitizers are mentioned in published European patent application EP 153904. Other preferred sensitizers are benzoperylene, 1,8-diphenyl-1,3,5,7-octatetraene, and 1,6-diphenyl-1,3,5-hexatriene as described in U.S. Patent 5,667,937. It will be recognized that an additional factor in the choice of sensitizer is the nature and primary wavelength of the source of actinic radiation.

The latent coloring component C) which forms colour or changes colour on contact with a photochemically generated photoacid is preferably a triaryl methane-, diphenyl methane-thiazine-, spiro-, lactam-, fluoran or isobenzofuranone-based colour former. Examples of Triarylmethane-based colour formers include, 3-3-bis(p-dimethylaminophenyl)-6-dimethylaminophthalide, 3,3-bis(p-dimethylaminophenyl)phthalide, 3-(p=dimethylaminophenyl)-3-(1,2-dimethylindole-3-yl)phthalide, 3-(p-dimethylaminophenyl)-3-(2-methylindole-3-yl)phthalide, 3,3-bis(1,2-dimethylindole-3-yl)-5-dimethylaminophthalide, 3,3-bis(1,2-dimethylindole-3-yl)-6-dimethylaminophthalide, 3,3-bis(9-ethylcarbazole-3-yl)-6-dimethylaminophthalide, 3,3-bis(2-phenylindole-3-yl)-6-dimethylaminophthalide, 3-p-dimethylaminophenyl-3-(1-methylpyrrole-3-yl)-6-dimethylaminophthalide, etc., especially triphenyl methanes e.g. Crystal Violet Lactone.

Diphenylmethane-based colour formers include 4,4'-bis-dimethylaminobenzhydryl benzyl ether, N-halophenyl-leucoauramine and N-2,4,5-trichlorophenyl-leucoauramine.

Thiazine-based colour formers include benzoyl-leucomethylene blue and p-nitrobenzoyl-leucomethylene blue.

Spiro-based colour formers include 3-methyl-spiro-dinaphthopyran, 3-ethyl-spiro-dinaphthopyran, 3-phenyl-spirodinapthopyran, 3-benzyl-spiro-dinaphthopyran, 3-methyl-naphtho-(6'-methoxybenzo)spiropyran and 3-propyl-spiro-dibenzopyran.

Lactam-based colour formers include rhodamine-b-anilinolactam, rhodamine-(p-nitroanilino)lactam and rhodamine-(o-chloroanilino)lactam.

Fluoran-based colour formers include 3,6-dimethoxyfluoran, 3,6-diethoxyfluoran, 3,6-dibutoxyfluoran, 3-dimethylamino-7-methoxyfluoran, 3-dimethylamino-6-methoxylfluoran, 3-dimethylamino-7-methoxyfluoran, 3-diethylamino-7-chlorofluoran, 3-diethylamino-6-methyl-7-chlorofluoran, 3-diethylamino-6,7-dimethylfuoran, 3-(N-ethyl-p-toluidino)-7-methylfluoran , 3-diethylamino-7-(N-acetyl-N-methylamino)fluoran, 3-diethylamino-7-N-methylaminofluoran, 3-diethylamino-7-dibenzylaminofluoran, 3-diethylamino-5-methyl-7-dibenzylaminofluoran, 3-diethylamino-7-(N-methyl-N-benzylamino)fluoran, 3-diethylamino-7-(N-chloroethyl-N-methylamino)fluoran, 3-diethylamino-7-diethylaminofluoran, 3-(N-ethyl-p-toluidino)-6-methyl-7-phenylaminofluoran, 3-(N-ethyl-p-toluidino)-6-methyl-7-phenylaminofluoran, 3-diethylamino-7-(2-carbomethoxy-phenylamino)fluoran, 3-(N-ethyl-N-isoamylamino)-6-methyl-7-phenylaminofluoran, 3-(N-cyclohexyl-N-methylamino)-6-methyl-7-phenylaminofluoran, 3-pyrrolidino-6-methyl-7-phenylaminofluoran, 3-piperidino-6-methyl-7-phenylaminofluoran, 3-diethylamino-6-methyl-7-xylidinofluoran, 3-diethylamino-7-(o-chlorophenylamino)fluoran, 3-dibutylamino-7-(o-chlorophenylamino)fluoran and 3-pyrrolidino-6-methyl-7-p-butylphenylaminofluoran.

Colour formers permitting the production of a wide range of colours are known and have been described, for example, by Peter Gregory in High-Technology Applications of Organic Colourants, Plenum Press, pages 124-134.

Preferred coloring components are the isobenzofuranone-based color formers and colour formers that are available under the tradenames of Copikem and Pergascript. Examples of these preferred coloring components are Copikem 20 (3,3-Bis (1-butyl -2-methyl-H-indol-3-yl) - 1-(3H)-isobenzofuranone), Copikem 5 (2'-Di (phenylmethy) amino-6'-(diethylamino)spiro(isobenzofuran-1 (3H),9'-(9H)xanthen)-3-one), Copikem 14 (a substituted phthalide), Copikem 7 (3-{(4Dimethylamino)-phenyl}-3 -(1-butyl-2methylindol-3yl) -6-dimethyamino) -1 (3H)-isobenzofuranone), Copikem 37 (2-(2-Octoxyphenyl)-4-(4-dimethylaminophenyl)-6-(phenyl)pyridine), Pergascript Black I-R (6"-(Dimethylamino)-3"-methyl - 2" - (phenylamino)spiro(isobenzofuran-1 (3H), 9" (9H)xanthem-3-one), and Pergascript Color Formers (like Diamiofluoran compounds, Bisaryl carbazolyl methane compounds, Phthalide compounds, Bisindolyl phthalide compounds, Aminofluoran compounds and Quinazoline compounds).

The amount of component C) is between 0.0001 and 1 wt%, preferably between 0.0005 and 0.1 wt%.

A component D) may be present in the resin composition used in the present invention. This component D) comprises a compound having at least one ethylenically unsaturation which can be polymerized with radicals. Specific examples of suitable ethylenic unsaturation are groups containing acrylate, methacrylate, styrene, vinylether, vinyl ester, N-substituted acrylamide, N-vinyl amide functionalities or maleate esters, and fumarate esters. Specifically, the ethylenic unsaturation is provided by a group containing acrylate, methacrylate, N-vinyl, or styrene functionality. For example, component D comprises one or more compounds having one or more (meth)acrylate functionalities.

The free-radical polymerizable acrylic materials that may be used in the composition are compounds that have, on average, at least one acrylic group which can be either the free acid or an ester. By "acrylic" is meant the group - CH=CR1 CO2R2, where R1 can be hydrogen or methyl and R2 can be hydrogen or alkyl. By "(meth)acrylate" is meant an acrylate, methacrylate or combinations thereof. The acrylic materials undergo polymerization and/or crosslinking reactions initiated by free radicals. The acrylic materials can be monomers, oligomers or polymers. It is preferred that the acrylic material be a monomer or oligomer.

Suitable as the acrylic component are, for example, the diacrylates of cycloaliphatic or aromatic diols, such as 1,4-dihydroxymethylcyclohexane, 2,2-bis(4-hydroxycyclohexyl)propane, 1,4-cyclohexanedimethanol, bis(4-hydroxycyclohexyl)methane, hydroquinone, 4,4-dihydroxybiphenyl, bisphenol A, bisphenol F, bisphenol S, ethoxylated or propoxylated bisphenol A, ethoxylated or propoxylated bisphenol F, or ethoxylated or propoxylated bisphenol S, and combinations thereof. Such acrylates are known and some of them are commercially available.

Suitable as aromatic tri(meth)acrylates are, for example, the reaction products of triglycidyl ethers of trihydric phenols, and phenol or cresol novolacs having three hydroxy groups with (meth)acrylic acid. Preferably the acrylic material contains 1,4-dihydroxymethyl-cyclohexane diacrylate, bisphenol A diacrylate, ethoxylated bisphenol A diacrylate and combinations thereof.

Compositions wherein the acrylic component contains an acrylate of bisphenol A diepoxide such as Ebecryl 3700® from UCB Chemical Corporation, Smyrna, Georgia, a mixed acrylate/epoxy compound of bisphenol A such as Ebecryl 3605® or an acrylate of 1,4-cyclohexanedimethanol are preferred for compositions used in this invention.

In addition to or instead of the aromatic or cycloaliphatic acrylic material, other acrylic materials can be present. Poly(meth)acrylates having functionality of greater than 2 may, where appropriate, be used in the compositions according to the invention. These can be, for example, tri, tetra, or pentafunctional monomeric or oligomeric aliphatic (meth)acrylates.

Suitable as aliphatic polyfunctional (meth)acrylates are, for example, the triacrylates and trimethacrylates of hexane-2,4,6-triol, glycerol, or 1,1,1-trimethylolpropane, ethoxylated or propoxylated glycerol, or 1,1,1-trimethylolpropane and the hydroxy group-containing tri(meth)acrylates which are obtained by the reaction of triepoxy compounds, such as, for example, the triglycidyl ethers of the mentioned triols, with (meth)acrylic acid. It is also possible to use, for example, pentaerythritol tetra-acrylate, bistrimethylolpropane tetra-acrylate, pentaerythritol monohydroxytri(meth)acrylate, or dipentaerythritol monohydroxypenta(meth)acrylate, and combinations thereof.

It is also possible to use hexafunctional urethane (meth)acrylates. Those urethane (meth)acrylates are known to the person skilled in the art and can be prepared in known manner, for example by reacting a hydroxy-terminated polyurethane with acrylic acid or methacrylic acid, or by reacting an isocyanate-terminated prepolymer with hydroxyalkyl (meth)acrylates to follow the urethane (meth)acrylate. Also useful are acrylates and methacrylates such as tris(2-hydroxyethyl)isocyanurate triacrylate.

The amount of component D) is for example between 5 and 60 wt%, preferably between 10 and 40 wt%.

In the compositions used in the invention a radical photoinitiator E) may be used, especially in combination with component D). Any type of photoinitiator that forms free radicals when the appropriate irradiation takes place can be used. Typical compounds of known photoinitiators are benzoins, such as benzoin, benzoin ethers, such as benzoin methyl ether, benzoin ethyl ether, and benzoin isopropyl ether, benzoin phenyl ether, and benzoin acetate, acetophenones, such as acetophenone, 2,2-dimethoxyacetophenone, 4-(phenylthio)acetophenone, and 1,1-dichloroacetophenone, benzil, benzil ketals, such as benzil dimethyl ketal, and benzil diethyl ketal, anthraquinones, such as 2-methylanthraquinone, 2-ethylanthraquinone, 2-tertbutylanthraquinone, 1-chloroanthraquinone, and 2-amylanthraquinone, also triphenylphosphine, benzoylphosphine oxides, such as, for example, 2,4,6-trimethylbenzoyldiphenylphosphine oxide (Lucirin TPO), benzophenones, such as benzophenone, and 4,4'-bis(N,N'-dimethylamino)benzophenone, thioxanthones and xanthones, acridine derivatives, phenazene derivatives, quinoxaline derivatives or I-phenyl-1,2-propanedione-2-O-benzoyloxime, I-aminophenyl ketones or I-hydroxyphenyl ketones, such as I-hydroxycyclohexyl phenyl ketone, phenyl (1-hydroxyisopropyl)ketone and 4-isopropylphenyl(1-hydroxyisopropyl)ketone, or triazine compounds, for example, 4"'-methyl thiophenyl-1-di(trichloromethyl)-3,5-S-triazine, S-triazine-2-(stilbene)-4,6-bistrichloromethyl, and paramethoxy styryl triazine, all of which are known compounds.

Especially suitable free-radical photoinitiators, which are normally used in combination with a He/Cd laser, operating at for example 325 nm, an Argon-ion laser, operating at for example 351 nm, or 351 and 364 nm, or 333, 351, and 364 nm, or a frequency tripled YAG solid state laser, having an output of 351 or 355 nm, as the radiation source, are acetophenones, such as 2,2-dialkoxybenzophenones and 1-hydroxyphenyl ketones, for example 1-hydroxycyclohexyl phenyl ketone, 2-hydroxy-1-{4-(2-hydroxyethoxy)phenyl}-2-methyl-1-propanone, or 2-hydroxyisopropyl phenyl ketone (also called 2-hydroxy-2,2-dimethylacetophenone), but especially 1-hydroxycyclohexyl phenyl ketone. Another class of free-radical photoinitiators comprises the benzil ketals, such as, for example, benzil dimethyl ketal. Especially an alpha-hydroxyphenyl ketone, benzil dimethyl ketal, or 2,4,6-trimethylbenzoyldiphenylphosphine oxide is used as photoinitiator.

Another class of suitable free radical photoinitiators comprises the ionic dye-counter ion compounds, which are capable of absorbing actinic rays and producing free radicals, which can initiate the polymerization of the acrylates. The compositions according to the invention that comprise ionic dye-counter ion compounds can thus be cured in a more variable manner using visible light in an adjustable wavelength range of 400 to 700 nanometers. Ionic dye-counter ion compounds and their mode of action are known, for example from published European patent application EP 223587 and U.S. Patents 4,751,102, 4,772,530 and 4,772,541. There may be mentioned as examples of suitable ionic dye-counter ion compounds the anionic dye-iodonium ion complexes, the anionic dye-pyryllium ion complexes and, especially, the cationic dye-borate anion compounds of the following formula 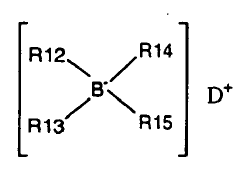 wherein D⁺ is a cationic dye and R₁₂, R₁₃, R₁₄, and R₁₅ are each independently of the others alkyl, aryl, alkaryl, allyl, aralkyl, alkenyl, alkynyl, an alicyclic or saturated or unsaturated heterocyclic group. Preferred definitions for the radicals R₁₂ to R₁₅ can be found, for example, in published European patent application EP 223587.

The compositions of the invention preferably comprise from about 0.01 to about 10% by weight of free-radical photoinitiator, based on the total weight of the composition.

The resin composition of the present invention may also contain a filler F). The filler may be any substance without special limitation. An inorganic substance is preferred from the point of view of the water-resisting capabilities and mechanical properties of the parts made of the resin composition of the invention. Examples of inorganic fillers are silica, glass powder, alumina, alumina hydrate, magnesium oxide, magnesium hydroxide, barium sulfate, calcium sulfate, calcium carbonate, magnesium carbonate, silicate mineral, diatomaceous earth, silica sand, silica powder, titanium oxide, aluminum powder, bronze, zinc powder, copper powder, lead powder, gold powder, silver dust, glass fiber, titanic acid potassium whiskers, carbon whiskers, sapphire whiskers, verification rear whiskers, boron carbide whiskers, silicon carbide whiskers, and silicon nitride whiskers.

The condition of the surface of the particles of the filler used and the impurities contained in filler from the manufacturing process can affect the curing reaction of the resin composition. In such cases, it is preferable to wash the filler particles or coat the particles with an appropriate primer as a method of improving the curing properties.

These inorganic fillers may also be surface-treated with a silane coupling agent. Silane coupling agents which can be used for this purpose include vinyl triclorosilane, vinyl tris (β-methoxyethoxy) silane, vinyltriethoxy silane, vinyltrimethoxy silane, γ-(methacryloxypropyl)trimethoxy silane, β-(3,4-epoxycyclohexyl)ethyltrimethoxy silane, γ-glycydoxypropyltrimethoxy silane, γ-glycydoxypropylmethyl diethoxy silane, N-β(aminoethyl)-γ-aminopropyltrimethoxy silane, N-β-(aminoethyl)-γ-aminopropylmethyldimethoxy silane, γ-aminopropyltriethoxysilane, N-phenyl-γ-amino propyl trimethoxy silane, γ-mercaptopropyl trimethoxysilane, and γ-chloropropyltrimethoxy silane.

The above inorganic fillers may be used singly or in combination of two or more.

The amount of filler may be present between 0 and 95 wt% relative to the total weight of the composition. For instance the filler may be present in 10-90 wt%, or for example between 20-80 wt%.

A hydroxyl-group containing material G) may be used in the present invention. Component G may be any liquid organic material having hydroxyl functionality of at least 1, and preferably at least 2. The material may be a liquid or a solid that is soluble or dispersible in the remaining components. Preferably the material is substantially free of any groups which substantially slowdown the curing reaction.

Preferably the organic material contains two or more primary or secondary aliphatic hydroxyl groups, by which is meant that the hydroxyl group is bonded directly to a non-aromatic carbon atom. Monomers, oligomers or polymers can be used. The hydroxyl equivalent weight, i.e., the number average molecular weight divided by the number of hydroxyl groups, is preferably in the range of 31 to 5000.

Representative examples of suitable organic materials having a hydroxyl functionality of 1 include alkanols, monoalkyl ethers of polyoxyalkyleneglycols, monoalkyl ethers of alkyleneglycols, and others, and combinations thereof.

Representative examples of useful monomeric polyhydroxy organic materials include alkylene and arylalkylene glycols and polyols, such as 1,2,4-butanetriol, 1,2,6-hexanetriol, 1,2,3-heptanetriol, 2,6-dimethyl-1,2,6-hexanetriol, (2R,3R)-(-)-2-benzyloxy-1,3,4-butanetriol, 1,2,3-hexanetriol, 1,2,3-butanetriol, 3-methyl-1,3,5-pentanetriol, 1,2,3-cyclohexanetriol, 1,3,5-cyclohexanetriol, 3,7,11,15-tetramethyl-1,2,3-hexadecanetriol, 2-hydroxymethyltetrahydropyran-3,4,5-triol, 2,2,4,4-tetramethyl-1,3-cyclobutanediol, 1,3-cyclopentanediol, trans-1,2-cyclooctanediol, 1,16-hexadecanediol, 3,6-dithia-1,8-octanediol, 2-butyne-1,4-diol, 1,3-propanediol, 1,4-butanediol, 1,5-pentanediol, 1,6-hexanediol, 1,7-heptanediol, 1,8-octanediol, 1,9-nonanediol, 1-phenyl-1,2-ethanediol, 1,2-cyclohexanediol, 1,5-decalindiol, 2,5-dimethyl-3-hexyne-2,5-diol, 2,7-dimethyl-3,5-octadiyne-2-7-diol, 2,3-butanediol, 1,4-cyclohexanedimethanol, and combinations thereof.

Representative examples of useful oligomeric and polymeric hydroxyl-containing materials include polyoxyethylene and polyoxypropylene glycols and triols of molecular weights from about 200 to about 10,000; polytetramethylene glycols of varying molecular weight; copolymers containing pendant hydroxy groups formed by hydrolysis or partial hydrolysis of vinyl acetate copolymers, polyvinylacetal resins containing pendant hydroxyl groups; hydroxy-terminated polyesters and hydroxy-terminated polylactones; hydroxy-functionalized polyalkadienes, such as polybutadiene; aliphatic polycarbonate polyols, such as an aliphatic polycarbonate diol; and hydroxy-terminated polyethers, and combinations thereof.

Preferred hydroxyl-containing monomers are 1,4-cyclohexanedimethanol and aliphatic and cycloaliphatic monohydroxy alkanols.

Preferred hydroxyl-containing oligomers and polymers include hydroxyl and hydroxyl/epoxy functionalized polybutadiene, 1,4-cyclohexanedimethanol, polycaprolactone diols and triols, ethylene/butylene polyols, and monohydroxyl functional monomers. Preferred examples of polyether polyols are polypropylene glycols of various molecular weights and glycerol propoxylate-B-ethoxylate triol. Especially preferred are linear and branched polytetrahydrofuran polyether polyols available in various molecular weights, such as for example 250, 650, 1000, 2000, and 2900 MW.

The composition used in the present invention may contain preferably up to 30 wt% of polyol, preferably between 3 and 20 weight percent.

Preferably the resin composition used in the present invention is a hybrid system, which means that the resin composition contains both radically and cationically polymerizable components and also radical and cationic photoinitiators.

The resin composition used in the present invention may comprise other cationically curable components like for example a cyclic ether component, vinyl ether component, cyclic lactone component, cyclic acetal component, cyclic thioether component, spiro orthoester component, and/or oxetane-functional component.

Oxetanes are components comprising one or more oxetane groups, *i*.*e*. one or more four-member ring structures according to formula (5): 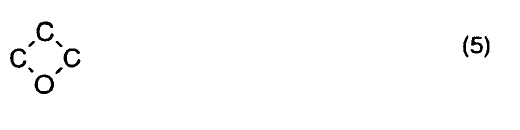 Examples of oxetanes include components represented by the following formula (6): 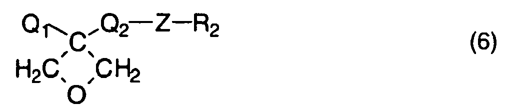 wherein
Q₁ represents a hydrogen atom, an alkyl group having 1 to 6 carbon atoms (such as a methyl, ethyl, propyl, or butyl group), a fluoroalkyl group having 1 to 6 carbon atoms, an allyl group, an aryl group, a furyl group, or a thienyl group;
Q₂ represents an alkylene group having 1 to 6 carbon atoms (such as a methylene, ethylene, propylene, or butylene group), or an alkylene group containing an ether linkage, for example, an oxyalkylene group, such as an oxyethylene, oxypropylene, or oxybutylene group
Z represents an oxygen atom or a sulphur atom; and
R₂ represents a hydrogen atom, an alkyl group having 1-6 carbon atoms (e.g. a methyl group, ethyl group, propyl group, or butyl group), an alkenyl group having 2-6 carbon atoms (e.g. a 1-propenyl group, 2-propenyl group, 2-methyl-1-propenyl group, 2-methyl-2-propenyl group, 1-butenyl group, 2-butenyl group, or 3-butenyl group), an aryl group having 6-18 carbon atoms (e.g. a phenyl group, naphthyl group, anthranyl group, or phenanthryl group), a substituted or unsubstituted aralkyl group having 7-18 carbon atoms (e.g. a benzyl group, fluorobenzyl group, methoxy benzyl group, phenethyl group, styryl group, cynnamyl group, ethoxybenzyl group), an aryloxyalkyl group (e.g. a phenoxymethyl group or phenoxyethyl group), an alkylcarbonyl group having 2-6 carbon atoms (e.g. an ethylcarbonyl group, propylcarbonyl group, or butylcarbonyl group), an alkoxy carbonyl group having 2-6 carbon atoms (e.g. an ethoxycarbonyl group, propoxycarbonyl group, or butoxycarbonyl group), an N-alkylcarbamoyl group having 2-6 carbon atoms (e.g. an ethylcarbamoyl group, propylcarbamoyl group, butylcarbamoyl group, or pentylcarbamoyl group), or a polyethergroup having 2-1000 carbon atoms.

The process for producing three-dimensional articles from the compositions used in the invention, as discussed above, generally involves exposure of successive thin layers of the liquid composition to actinic radiation. A thin layer of the photosensitive composition of the invention is coated onto a surface. This is most conveniently done if the composition is a liquid. However, a solid composition can be melted to form a layer. Also a viscosity reducible composition maybe used which may be applied under shear. After coating of a thin layer, this layer is then exposed imagewise to actinic radiation to form a first imaged cross-section. The radiation must provide sufficient exposure to cause substantial curing of the photosensitive composition in the exposed areas. By "substantial curing" it is meant that the photosensitive composition has reacted to an extent such that the exposed areas are physically differentiable from the unexposed areas. For liquid, gel, paste or semi-solid photosensitive compositions, the cured areas will have hardened or solidified to a non-fluid form. For solid photosensitive compositions, the exposed areas will have a higher melting point than the non-exposed areas. Preferably, the exposure is such that portions of each successive layer are adhered to a portion of a previously exposed layer or support region, or to portions of a platform surface. An additional (second) thin layer of photosensitive composition is then coated onto the first imaged cross-section and imagewise exposed to actinic radiation to form an additional (second) imaged cross-section. These steps are repeated with the "nth" thin layer of photosensitive composition being coated onto the "(n-1)th" imaged cross-section and exposing to actinic radiation. The repetitions are carried out a sufficient number of times to build up the entire three-dimensional article.

The radiation is preferably in the range of 280-650 nm. Any convenient source of actinic radiation can be used, but lasers are particularly suitable. Useful lasers include HeCd, argon, nitrogen, metal vapor, and NdYAG lasers. The exposure energy is for example in the range of 10-500 mJ/cm², preferably in the range between 20 and 250 mJ/cm², for instance between 30 and 150 mJ/cm². Suitable methods and apparatus for carrying out the exposure and production of three-dimensional articles have been described in, for example, U.S. Patents 4,987,044, 5,014,207, and 5,474,719, which teaches the use of pseudoplastic, plastic flow, thixotropic, gel, semi-solid and solid photopolymer materials in the solid imaging process. These US-patents are incorporated herein by reference.

In general, the three-dimensional article formed by exposure to actinic radiation, as discussed above, is not fully cured, by which is meant that not all of the reactive material in the composition has reacted. Therefore, there is often an additional step of postcuring the article. This can be accomplished by further irradiating with actinic radiation, heating, or both. Exposure to actinic radiation can be accomplished with any convenient radiation source, generally a UV light, for a time ranging from about 10 to over 60 minutes. Heating is generally carried out at a temperature in the range of about 75-200 °C, for a time ranging from about 10 to over 60 minutes.

It has been surprisingly found, that thermal postcure may have an influence on the color of the cured part. Thermal postcure may 'bleach' the article giving an article having a higher L value than the article showed after preparation with for example a laserbeam. This gives the opportunity to maintain the advantages of cleaning a part made from for example a filled resin, but gives the flexibility to choose intensity of color upon request of the customer by simple postcure methods. The 'a' and 'b' values may be reduced to values closer to zero. Bleaching takes place for example when thermal postcure is performed at high temperatures for prolonged periods of time, like for example 2 hours postcure at 160 °C.

### Experimental part

Color measurement is performed with a Macbeth Color Eye 7000 spectrophotometer, or equivalent, whereby the instrument is calibrated using the white tile and the black trap (zero reflectance) with Large Area View (LAV) according to the manufacturer's instructions. The measurement conditions are selected as follows: Large Area View (LAV) and Specular Component Included (SCI), D65 illuminant and 10° observer. Color measurements can be performed on films or flat surfaces with the Macbeth Color Eye 7000, or also with manual chromameters which are commercially available. The films have been placed against a white background of a Leneta card, having a background color of L 94.5, a = -0.9 and b = 4.7.

Samples have been prepared by taking resin from a container after homogenizing the resin in the container by mechanical stirring. Samples for color measurement have been prepared of cured ((semi) transparent) films, paste resins with fillers and parts made from the paste resins. Sample of transparent resin have been prepared by making a resin film of 20 mils (0.51 mm) thickness and curing the resin with a D-lamp using two doses radiation of 0.13 J/cm² under a nitrogen atmosphere. Samples of filled resin have been prepared by making a 6 mils (0.15 mm) film using 200 mJ/cm² radiation.

Absorbance of transparant liquid resins has been measured by putting a resin in a 1 cm quartz cuvet and measuring the UV-VIS spectrum between 400 and 650 nm in a standard spectrophotometer. The highest absorbance in that wavelength range is taken as the absorbance value. Absorbance of a cured transparant part is measured on a part that has been made on a standard SLA machine equipped with an Argon-Ion laser. The exposure given was 85 mJ/cm2, to build a part having a thickness of 250 mil (0.635 cm) with layers of 6 mil (0.15 mm).

### Examples

A commercially available compound SOMOS ® 7720 was taken as a starting epoxy based resin composition. Somos ® 7720 contains between 40 and 80 wt% of epoxy compounds, between 3 and 15 wt% polyols, between 10 and 40 wt% of acrylates, radical and cationic photoinitiators.

Various Copikem latent coloring components C) were added to the base Somos 7720 composition in different amounts.
The absorbance of Somos 7720 with or without Copikem latent coloring components is the same: the absorbance in the visible region between 400 and 650 nm is lower than 0.2, measured on a 1 cm thick liquid sample of the resin composition. The absorbance in the region between 450 and 700 nm is even below 0.10. All resin compositions did not show any color except the natural slight yellow color, which may be present in these types of resin compositions.

Absorbance has been measured by making a standard UV-VIS spectrum in the region between 400 and 650 nm on a cured sample having a thickness of 250 mil (0.635 cm). The maximum absorbance is the highest absorbance measured in the spectrum.

| Component C (wt%) | 7720 | Ex 1 | Ex 2 | Ex 3 | Ex 4 | Ex 5 | Ex 6 |
|---|---|---|---|---|---|---|---|
| Copikem 20-magenta | - | 0.0018 | 0.003 | - | - | 0.0014 | 0.0014 |
| Copikem-4 black | - | - | - | 0.0085 | - | 0.0085 | - |
| Copikem -14 orange | - | - | - | - | 0.0085 | 0.0030 | 0.0030 |
| Pergascript Black I-R | - | - | - | - | - | - | 0.0085 |
| Max absorbance | 0.27 | 0.76 | 1.3 | 2.31 | 1.44 | 2.65 | 3.3 |
| At wavelength (nm) | 400 | 530 | 530 | 580 | 450 | 450 | 450 |

Copikem 20 is (3,3-Bis (1-butyl -2-methyl-H-indol-3-yl) - 1-(3H)-isobenzofuranone), Copikem 4 (CAS No. 29512-49-0) is 6'-(diethylamino)-3'-methyl-2'-(phenylamino)spiro(isobenzofuran-1 (3H0,9'-(9H)xanthen-3-one. Copikem 14 (Orange) (CAS No. 67697-15-0) is a substituted phthalide Pergascript Black I-R is (6"-(Dimethylamino)-3"-methyl - 2" - (phenylamino)spiro(isobenzofuran-1 (3H), 9" (9H)xanthem-3-one).

All examples show that addition of component C gives objects having a color, which color is different than the original natural color of the resin composition. Addition of higher amounts of coloring agent (examples 1 and 2) gives a higher maximum absorbance. Examples 2 to 4 show that different types of coloring agents may be used. Example 5 and 6 show that also combination of coloring agents is possible. All parts show a uniform coloring. The color forms during the (first) exposure of the resin to irradiation. Further post treatment of the part with UV does not substantially change the color and/or the absorbance of the part.

Surprisingly, the physical properties of the colored parts are substantially the same as the part made from the resin having no component C. The part made in example 6 (with a UV-postcuring treatment) has the following properties (properties from 7720 example without coloring component in brackets): Flexural Modulus data: Young's modulus 230 (236), Flex strength KSI 7.00 (7.8), % strain 4.35 (5.1).

### Example 7

The resin of example 6 and the commercial Somos 7720, having no latent coloring component C, have been cured under nitrogen with two doses of 0.13 J/cm² radiation of a D lamp into a 20 mil (0.51 mm) thick film. Color measurement has been performed with a Macbeth Color Eye 7000 spectrophotometer. Results are shown in table 2.

**Table 2**

| | 7720 film | Example 6 resin film |
|---|---|---|
| L | 91.3 | 77 |
| 'a' | -2 | 0 |
| 'b' | 8 | 10 |

### Examples 8-10

A base resin containing 4.1 wt% 3,4-Epoxy Cyclohexyl Methyl-3,4-Epoxy Cyclohexyl Carboxylate (Uvacure 1500), 6.6 wt% 3-Ethyl-3-(hydroxymethyl)oxetane (UVR6000), 16.4 wt% Epon 825, 4 wt% Dipentaerithritol pentaacrylate (Sartomer SR-399), 63 wt% silica (Siltex 44), 1.3 wt% Triton X-100, 2.9 wt% Thixatrol XT, 0.23 wt% 1-Hydroxycyclohexyl phenyl ketone (Irgacure 184), and 1.3 wt% CPI-6976 (a mixture of Sulfonium(thiodi-4,1-phenylene)bis[diphenyl-bis[(OC-6-11)hexafluoroantimonate(1-)]] and p-Thiophenoxyphenyldiphenylsulfonium) is mixed with different amounts of latent coloring component C (Copikem 20 Magenta). 6 mils films were prepared by applying a 6 mil film onto a petridish, irradiating it with an solid state laser, having a wavelength of 365 nm, with an exposure of 200 mJ/cm². The film was cleared with tri(propylene glycol) methyl ether and rinsed with isopropylalcohol before postcure. Two thin films for each sample were postcured in a postcuring apparatus for 15 minutes on each side of the film. The postcuring apparatus (3D systems) contains a 10 bulb unit having Philips TLK/05 40W bulbs.
Two other thin films for each sample were thermal postcured in an oven for two hours at 160 °C, with a warming up time of 2 hours and a cooling down time of 2 hours. The color is measured both of the resins before cure and of the parts made after photofabrication and either UV-postcure or thermal postcure.
The uncured resin has the following color characteristics L = 92, a = -0.8, b = 5.

| Example | Wt% dye | Object after UV-cure and UV postcure | | | | Object after UV-cure and thermal postcure | | | |
|---|---|---|---|---|---|---|---|---|---|
| | | L | Lc/Lu | A | B | L | Lc/Lu | a | b |
| A | 0 | 92 | 1 | -0.8 | 6 | 92 | 1 | -0.8 | 6 |
| 8 | 0.00053 | 81 | 0.88 | 13 | -3.3 | 87 | 0.95 | -0.5 | 8.7 |
| 9 | 0.00264 | 73 | 0.79 | 34 | -15 | 87 | 0.95 | 3.1 | 4.8 |
| 10 | 0.01190 | 60 | 0.65 | 48 | -20 | 78 | 0.85 | 15 | -3.1 |

## Claims

1. A process for forming a three-dimensional article comprising:
(1) coating a layer of a radiation curable resin composition onto a surface;
(2) exposing the layer imagewise to actinic radiation to form an imaged cross-section, wherein the radiation is of sufficient intensity to cause substantial curing of the layer in the exposed areas;
(3) coating a layer of the composition onto the previously exposed imaged cross-section;
(4) exposing said thin layer from step (3) imagewise to actinic radiation to form an additional imaged cross-section, wherein the radiation is of sufficient intensity to cause substantial curing and coloring of the thin layer in the exposed areas and to cause adhesion to the previously exposed imaged cross-section;
(5) repeating steps (3) and (4) a sufficient number of times in order to build up the three-dimensional article;
wherein the radiation curable resin composition comprises
A) at least one epoxy compound
B) a cationic photoinitiator, and
C) a latent coloring component, and
wherein the resin composition has a first color or no color before cure and wherein a three dimensional object made from the resin by subjecting the resin to radiation shows a second color which is different from the color of the resin composition before cure and wherein the amount of component C is between 0.0001 and 0.1 wt%.

2. A process for forming a three-dimensional article comprising:
(1) coating a layer of a radiation curable resin composition onto a surface;
(2) exposing the layer imagewise to actinic radiation to form an imaged cross-section, wherein the radiation is of sufficient intensity to cause substantial curing of the layer in the exposed areas;
(3) coating a layer, of the composition onto the previously exposed imaged cross-section;
(4) exposing said thin layer from step (3) imagewise to actinic radiation to form an additional imaged cross-section, wherein the radiation is of sufficient intensity to cause substantial curing and coloring of the thin layer in the exposed areas and to cause adhesion to the previously exposed imaged cross-section;
(5) repeating steps (3) and (4) a sufficient number of times in order to build up the three-dimensional article;
wherein the radiation curable resin composition comprises
A) at least one epoxy compound
B) a cationic photoinitiator and
C) a latent coloring component, and
wherein the resin composition shows
i an absorbance of visible light in the region between 400 and 650 nm of less than 0.3 measured on a sample having a thickness of 1 cm; or
ii a L-value between 90 and 100 in the CIELAB L*a*b color space, measured on a 0.5 mm sample against a white Leneta card background.
and wherein the amount of component C is between 0.0001 and 0.1 wt%.

3. The process according to claim 2, wherein the absorbance of visible light of the resin is less than 0.2.

4. The process according to anyone of claims 1-3, wherein a three dimensional object made from the resin composition by subjecting the resin to radiation shows color and has
i a maximum absorbance of visible light of at least 1.0 measured in the range from 400 to 650 nm on a sample having a thickness of 250 mil (0.635 cm); or
ii a L-value between 0 and 85.

5. The process according to claim 4, wherein the maximum absorbance is more than 1.5, or wherein the L-value is between 20 and 75.

6. The process according to anyone of claims 1-5, wherein the difference between the 'a' and/or 'b' values of the object and the resin are larger than 20 units, wherein 'a' and 'b' relate to the L*a*b color space.

7. The process according to anyone of claims 1-6, wherein the resin composition contains a filler.

8. The process according to anyone of claims 1-7, wherein a component A is present that contains a cycloaliphatic diepoxide.

9. The process according to anyone of claims 1-8, wherein a component D) is present which contains an ethylenically unsaturation.

10. The process according to claim 9, wherein component D) comprises a (meth)acrylate functionality.

11. The process according to anyone of claims 9-10, wherein component D comprises a mono or di acrylate of bisphenol A diepoxide.

12. The process according to anyone of claims 1-11, wherein the resin composition contains a radical photoinitiator E).

13. The process according to anyone of claims 1-12, wherein the resin composition contains at least two epoxy compounds.

14. The process according to anyone of claims 1-13, wherein the resin composition contains a polyol F).

15. The process according to anyone of claims comprising a resin composition comprising
A) 30-80 wt% of at least one epoxy compound
B) 0.2 -10 wt% of a cationic photoinitiator,
C) 0.0001-0.1 wt% of a latent coloring component
D) 5-60 wt% of a (meth)acrylate component
E) 0.01-10 wt% of a radical photoinitiator
F) a polyol
wherein the resin composition has a first color or no color before cure and wherein a three dimensional object made from the resin by subjecting the resin to radiation shows a second color which is different from the color of the resin composition before cure.

16. The process according to anyone of the above claims, wherein the composition is a gel, paste or semi-solid.

## Patentansprüche

1. Verfahren zur Herstellung eines dreidimensionalen Gegenstands, bei dem man:
(1) auf eine Oberfläche eine Schicht aus einer strahlenhärtbaren Harzzusammensetzung aufbringt;
(2) die Schicht bildmäßig mit aktinischer Strahlung belichtet, was einen bebilderten Querschnitt ergibt, wobei die Strahlung eine zur Bewirkung einer weitgehenden Härtung der Schicht in den belichteten Bereichen ausreichende Intensität aufweist;
(3) auf den zuvor belichteten bebilderten Querschnitt eine Schicht aus der Zusammensetzung aufbringt;
(4) die dünne Schicht aus Schritt (3) bildmäßig mit aktinischer Strahlung belichtet, was einen zusätzlichen bebilderten Querschnitt ergibt, wobei die Strahlung eine zur Bewirkung einer weitgehenden Härtung und Färbung der dünnen Schicht in den belichteten Bereichen und zur Bewirkung von Haftung auf dem zuvor bebilderten Querschnitt ausreichende Intensität hat;
(5) die Schritte (3) und (4) ausreichend oft wiederholt, um den dreidimensionalen Gegenstand aufzubauen;
wobei die strahlenhärtbare Harzzusammensetzuung
A) mindestens eine Epoxidverbindung,
B) einen kationischen Photoinitiator und
C) eine latente farbgebende Komponente enthält,
wobei die Harzzusammensetzung vor der Härtung eine erste Farbe oder keine Farbe aufweist und ein durch Bestrahlen des Harzes aus dem Harz hergestellter dreidimensionaler Gegenstand eine zweite Farbe zeigt, welche von der Farbe der Harzzusammensetzung vor der Härtung verschieden ist, und die Menge der Komponente C zwischen 0,0001 und 0,1 Gew.-% liegt.

2. Verfahren zur Herstellung eines dreidimensionalen Gegenstands, bei dem man:
(1) auf eine Oberfläche eine Schicht aus einer strahlenhärtbaren Harzzusammensetzung aufbringt;
(2) die Schicht bildmäßig mit aktinischer Strahlung belichtet, was einen bebilderten Querschnitt ergibt, wobei die Strahlung eine zur Bewirkung einer weitgehenden Härtung der Schicht in den belichteten Bereichen ausreichende Intensität aufweist;
(3) auf den zuvor belichteten bebilderten Querschnitt eine Schicht aus der Zusammensetzung aufbringt;
(4) die dünne Schicht aus Schritt (3) bildmäßig mit aktinischer Strahlung belichtet, was einen zusätzlichen bebilderten Querschnitt ergibt, wobei die Strahlung eine zur Bewirkung einer weitgehenden Härtung und Färbung der dünnen Schicht in den belichteten Bereichen und zur Bewirkung von Haftung auf dem zuvor bebilderten Querschnitt ausreichende Intensität hat;
(5) die Schritte (3) und (4) ausreichend oft wiederholt, um den dreidimensionalen Gegenstand aufzubauen;
wobei die strahlenhärtbare Harzzusammensetzung
A) mindestens eine Epoxidverbindung,
B) einen kationischen Photoinitiator und
C) eine latente farbgebende Komponente enthält,
wobei die Harzzusammensetzung
i ein Absorptionsmaß für sichtbares Licht im Bereich zwischen 400 und 650 nm von weniger als 0,3, gemessen an einer Probe mit einer Dicke von 1 cm; oder
ii einen L-Wert zwischen 90 und 100 im CIELAB L*a*b-Farbenraum, gemessen an einer 0,5-mm-Probe gegen einen weißen Leneta-Karten-Hintergrund,
zeigt
und die Menge der Komponente C zwischen 0,0001 und 0,1 Gew.-% liegt.

3. Verfahren nach Anspruch 2, bei dem das Harz ein Absorptionsmaß für sichtbares Licht von weniger als 0,2 aufweist.

4. Verfahren nach einem der Ansprüche 1-3, bei dem ein durch Bestrahlen des Harzes aus der Harzzusammensetzung hergestellter dreidimensionaler Gegenstand Farbe zeigt und
i ein maximales Absorptionsmaß für sichtbares Licht von mindestens 1,0, gemessen im Bereich von 400 bis 650 nm an einer Probe mit einer Dicke von 250 Millizoll (0,635 cm); oder
ii einen L-Wert zwischen 0 und 85
zeigt.

5. Verfahren nach Anspruch 4, bei dem das maximale Absorptionsmaß mehr als 1,5 beträgt oder der L-Wert zwischen 20 und 75 liegt.

6. Verfahren nach einem der Ansprüche 1-5, bei dem die Differenz zwischen den "a"- und/oder "b"-Werten des Gegenstands und des Harzes größer als 20 Einheiten ist, wobei "a" und "b" sich auf den L*a*b-Farbenraum beziehen.

7. Verfahren nach einem der Ansprüche 1-6, bei dem die Harzzusammensetzung einen Füllstoff enthält.

8. Verfahren nach einem der Ansprüche 1-7, bei dem eine Komponente A vorliegt, die ein cycloaliphatisches Diepoxid enthält.

9. Verfahren nach einem der Ansprüche 1-8, bei dem eine Komponente D) vorliegt, die eine ethylenische Ungesättigtheit enthält.

10. Verfahren nach Anspruch 9, bei dem die Komponente D) eine (Meth)acrylatfunktionalität umfaßt.

11. Verfahren nach einem der Ansprüche 9-10, bei dem die Komponente D ein Mono- oder Diacrylat von Bisphenol-A-diepoxid umfaßt.

12. Verfahren nach einem der Ansprüche 1-11, bei dem die Harzzusammensetzung einen radikalischen Photoinitiator E) enthält.

13. Verfahren nach einem der Ansprüche 1-12, bei dem die Harzzusammensetzung mindestens zwei Epoxidverbindungen enthält.

14. Verfahren nach einem der Ansprüche 1-13, bei dem die Harzzusammensetzung ein Polyol F) enthält.

15. Verfahren nach einem der Ansprüche, umfassend eine Harzzusammensetzung, die
A) 30-80 Gew.-% mindestens einer Epoxidverbindung
B) 0,2-10 Gew.-% eines kationischen Photoinitiators
C) 0,0001-0,1 Gew.-% einer latenten farbgebenden Komponente
D) 5-60 Gew.-% einer (Meth)acrylatkomponente
E) 0,01-10 Gew.-% eines radikalischen Photoinitiators
F) ein Polyol,
enthält, wobei die Harzzusammensetzung vor der Härtung eine erste Farbe oder keine Farbe aufweist und ein durch Bestrahlen des Harzes aus dem Harz hergestellter dreidimensionaler Gegenstand eine zweite Farbe zeigt, welche von der Farbe der Harzzusammensetzung vor der Härtung verschieden ist.

16. Verfahren nach einem der vorhergehenden Ansprüche, bei dem es sich bei der Zusammensetzung um ein Gel, eine Paste oder eine halbfeste Substanz handelt.

## Revendications

1. Procédé de formation d'un article tridimensionnel comprenant :
(1) le dépôt d'une couche d'une composition de résine durcissable par rayonnement sur une surface ;
(2) l'exposition de la couche sous forme d'image à un rayonnement solaire pour former une section imagée, dans laquelle le rayonnement est d'intensité suffisante pour provoquer un durcissement substantiel de la couche dans les zones exposées ;
(3) le dépôt d'une couche de la composition sur la section imagée préalablement exposée ;
(4) l'exposition de ladite couche mince de l'étape (3) sous forme d'image à un rayonnement solaire pour former une section imagée supplémentaire, dans laquelle le rayonnement est d'intensité suffisante pour provoquer un durcissement substantiel et une coloration de la couche mince dans les zones exposées et pour provoquer une adhérence à la section imagée préalablement exposée ;
(5) la répétition des étapes (3) et (4) un nombre suffisant de fois afin de construire l'article tridimensionnel ;
dans lequel la composition de résine durcissable par rayonnement comprend
A) au moins un composé époxy,
B) un photoinitiateur cationique, et
C) un composant colorant latent, et
dans lequel la composition de résine possède une première couleur ou aucune couleur avant durcissement et dans lequel un objet tridimensionnel fabriqué à partir de la résine en soumettant la résine à un rayonnement présente une seconde couleur qui est différente de la couleur de la composition de résine avant durcissement et dans lequel la quantité de composant C se situe entre 0,0001 et 0,1 % en poids.

2. Procédé de formation d'un article tridimensionnel comprenant :
(1) le dépôt d'une couche d'une composition de résine durcissable par rayonnement sur une surface ;
(2) l'exposition de la couche sous forme d'image à un rayonnement solaire pour former une section imagée, dans laquelle le rayonnement est d'intensité suffisante pour provoquer un durcissement substantiel de la couche dans les zones exposées ;
(3) le dépôt d'une couche de la composition sur la section imagée préalablement exposée ;
(4) l'exposition de ladite couche mince de l'étape (3) sous forme d'image à un rayonnement solaire pour former une section imagée supplémentaire, dans laquelle le rayonnement est d'intensité suffisante pour provoquer un durcissement substantiel et une coloration de la couche mince dans les zones exposées et pour provoquer une adhérence à la section imagée préalablement exposée ;
(5) la répétition des étapes (3) et (4) un nombre suffisant de fois afin de construire l'article tridimensionnel ;
dans lequel la composition de résine durcissable par rayonnement comprend
A) au moins un composé époxy,
B) un photoinitiateur cationique, et
C) un composant colorant latent, et
dans lequel la composition de résine présente
i. une absorbance de la lumière visible dans la région entre 400 et 650 nm de moins de 0,3 mesurée sur un échantillon possédant une épaisseur de 1 cm ; ou
ii. une valeur L entre 90 et 100 dans l'espace des couleurs CIELAB L*a*b, mesurée sur un échantillon de 0,5 mm contre un fond de carte Leneta blanche,
et dans lequel la quantité de composant C se situe entre 0,0001 et 0,1 % en poids.

3. Procédé selon la revendication 2, dans lequel l'absorbance de la lumière visible de la résine est inférieure à 0,2.

4. Procédé selon l'une quelconque des revendications 1 à 3, dans lequel un objet tridimensionnel fabriqué à partir de la composition de résine en soumettant la résine à un rayonnement présente une certaine couleur et possède
i. une absorbance maximale de la lumière visible d'au moins 1,0 mesurée dans la gamme de 400 à 650 nm sur un échantillon possédant une épaisseur de 250 mil (0,635 cm) ; ou
ii. une valeur L entre 0 et 85.

5. Procédé selon la revendication 4, dans lequel l'absorbance maximale est supérieure à 1,5, ou dans lequel la valeur L se situe entre 20 et 75.

6. Procédé selon l'une quelconque des revendications 1 à 5, dans lequel la différence entre les valeurs 'a' et/ou 'b' de l'objet et de la résine est supérieure à 20 unités, dans lequel 'a' et 'b' se rapportent à l'espace des couleurs L*a*b.

7. Procédé selon l'une quelconque des revendications 1 à 6, dans lequel la composition de résine contient une charge.

8. Procédé selon l'une quelconque des revendications 1 à 7, dans lequel un composant A) qui contient un diépoxyde cycloaliphatique est présent.

9. Procédé selon l'une quelconque des revendications 1 à 8, dans lequel un composant D) qui contient une insaturation éthylénique est présent.

10. Procédé selon la revendication 9, dans lequel le composant D) comprend une fonctionnalité (méth)acrylate.

11. Procédé selon l'une quelconque des revendications 9 et 10, dans lequel le composant D) comprend un diépoxyde de mono- ou diacrylate de bisphénol A.

12. Procédé selon l'une quelconque des revendications 1 à 11, dans lequel la composition de résine contient un photoinitiateur de radicaux E).

13. Procédé selon l'une quelconque des revendications 1 à 12, dans lequel la composition de résine contient au moins deux composés époxy.

14. Procédé selon l'une quelconque des revendications 1 à 13, dans lequel la composition de résine contient un polyol F).

15. Procédé selon l'une quelconque des revendications comprenant une composition de résine comprenant
A) 30-80 % en poids d'au moins un composé époxy,
B) 0,2-10 % en poids d'un photoinitiateur cationique,
C) 0,0001-0,1 % en poids d'un composant colorant latent,
D) 5-60 % en poids d'un composant de (méth)acrylate,
E) 0,01-10 % en poids d'un photoinitiateur de radicaux,
F) un polyol,
dans lequel la composition de résine possède une première couleur ou aucune couleur avant durcissement et dans lequel un objet tridimensionnel fabriqué à partir de la résine en soumettant la résine à un rayonnement présente une seconde couleur qui est différente de la couleur de la composition de résine avant durcissement.

16. Procédé selon l'une quelconque des revendications précédentes, dans lequel la composition est un gel, une pâte ou un semi-solide.
